Europäisches Patentamt

European Patent Office

Office européen des brevets

(19)

(11) Publication number: **0 072 273**
A2

# (12) EUROPEAN PATENT APPLICATION

(21) Application number: **82401315.5**

(22) Date of filing: **12.07.82**

(51) Int. Cl.³: **H 01 L 21/60, H 01 L 23/48**

(30) Priority: **13.07.81 US 282568**

(43) Date of publication of application: **16.02.83** Bulletin **83/7**

(84) Designated Contracting States: **DE FR GB IT NL**

(71) Applicant: **FAIRCHILD CAMERA & INSTRUMENT CORPORATION, 464 Ellis Street, Mountain View California 94042 (US)**

(72) Inventor: **Phy, William S., 25616 Moody Road, Los Altos Hills California 94022 (US)**

(74) Representative: **Chareyron, Lucien et al, Schlumberger Limited 42, rue Saint-Dominique, F-75340 Paris Cedex 07 (FR)**

(54) Low temperature integrated circuit die attachment process.

(57) A method of attaching an integrated circuit die to an underlying substrate includes the steps of coating the back surface of the integrated circuit with silver, coating the surface of the substrate with at least one of gold, silver, platinum and palladium and attaching the surface of the integrated circuit to the surface of the substrate with a melted composition of gold and tin. The gold/tin is typically 80% gold and 20% tin by weight.

50.3991

LOW TEMPERATURE DIE ATTACH PROCESS

BACKGROUND OF THE INVENTION

Field of the Invention

This invention relates to integrated circuits, and in particular, to a method for attaching an integrated circuit to an underlying substrate.

Description of the Prior Art

In the manufacture of integrated circuits, silicon wafers containing many separate integrated circuits are fabricated and then cut into individual circuits known as die. The functional individual circuits are then packaged using a variety of known techniques.

In one such prior art technique an individual integrated circuit die is attached to an underlying substrate using a metallurgical process. According to this technique gold is first deposited on the back of the silicon wafer. The substrate to which an individual die is to be attached is then coated with a desired material, typically gold, silver, platinum, palladium, or combinations thereof. The coated wafer is cut into dice, and an individual gold backed die is placed in contact with the coating on the substrate and heated. The gold on the die and the coating on the substrate then form an alloy which serves to electrically and physically connect the back of the integrated circuit die to the substrate.

Unfortunately such prior art processes must be very carefully controlled because if the gold-silicon interface is under-alloyed it will not provide adhesion, and if over- alloyed will produce a surface which will not wet to enable physical joining of the die and substrate. Additionally, in the manufacture of many integrated circuits, for example, N-Channel MOS devices, the resulting devices are extremely sensitive to gold contamination. Finally, such prior art processes are difficult to use in the manufacture of heat sensitive products such as charge coupled device image sensors or memories.

SUMMARY OF THE INVENTION

According to the invention a method for attaching an integrated circuit to a substrate includes the step of coating a surface of the integrated circuit with a composition which includes silver, coating a surface of substrate with a metal or alloy chosen from the group of gold, silver, platinum and palladium, and attaching the surface of the integrated circuit to the surface of the substrate with a melted composition of gold and tin. Gold, platinum, and platinum-palladium have been found particularly suitable for coating the substrate. Typically, the gold/tin composition will be the eutectic composition, in other words, 80 percent gold and 20 percent tin by weight. Further, in the preferred embodiment in joining the die to the substrate the gold/tin composition is held at or above its melting point for a relatively short period of time, typically on the order of 0.5 to 4 minutes.

The process of this invention permits an integrated circuit die to be attached to an underlying substrate at a relatively low temperature with high reliability and thermal conductivity. For reasons not yet fully understood, once the die is attached to the substrate the remelt temperature to remove or displace the die is substantially higher than the original melt temperature. This phenomenon allows the use of subsequent high temperature processing in conjunction with the assembled die and substrate without loosening the die/substrate connection.

BRIEF DESCRIPTION OF THE DRAWINGS

Fig. 1 is a cross-sectional view of an integrated circuit die with backside coating.

Fig. 2 is a cross-sectional view of the die, preform and substrate prior to melting the preform.

Fig. 3 is a cross-sectional view of the structure of Fig. 2 following melting of the preform.

DESCRIPTION OF THE PREFERRED EMBODIMENT

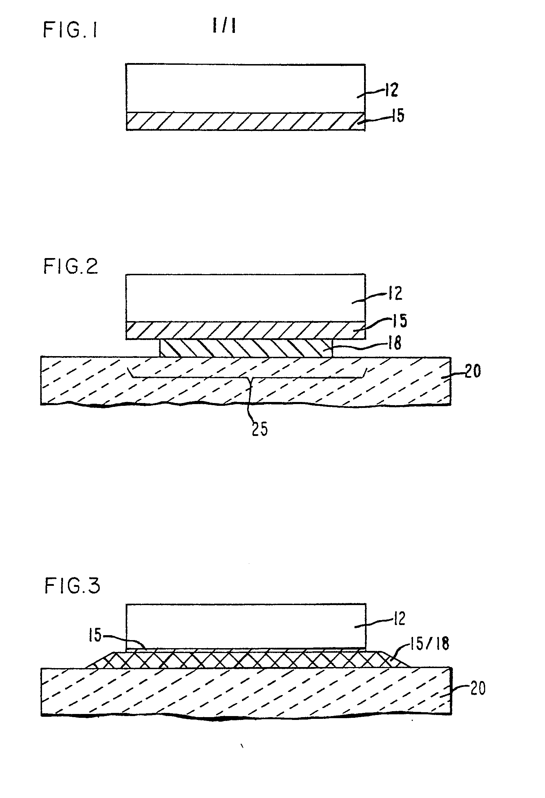

In the preferred embodiment the backside of a silicon wafer containing a plurality of integrated circuits is prepared for the die attach process by being coated with chromium and silver. This is typically accomplished by a phased deposition process in which chromium is initially deposited on the silicon wafer backside and then silver phased into the deposition while chromium is phased out. The result is a graded concentration profile which extends from nearly pure chromium in contact with the silicon to substantially pure silver at the outer surface. Chromium serves to adhere the silver to the silicon. A die 12 with coating 15 from such a wafer is shown in cross-section in Figure 1.

As shown in Figure 2 a gold/tin preform of substantially eutectic composition is placed between die 12 and substrate 20 a surface 25 of which has been coated with a metal comprising at least one of gold, silver, platinum and palladium. The term "preform" is intended to denote a piece of gold/tin of suitable shape and size to result in a desired molten amount of material when the preform is heated above its melting temperature. In a preferred embodiment preform 18 comprises a eutectic composition of gold and tin, that is, substantially 80 percent gold and 20 percent tin by weight. The use of the eutectic composition is particularly advantageous because the low melting temperature (288$^\circ$C) enables the entire process to be carried out at relatively low temperatures.

Next, substrate 20, preform 18, and the die 12 including chromium/silver coating 15, are heated to at least the melting point of preform 18. This step is illustrated in Fig. 3. In the preferred embodiment when preform 18 comprises 80 percent gold and 20 percent tin by weight, the melting temperature is approximately 288°C. Heating the structure to 300°C has been found sufficient to reliably and completely melt the preform.

Once the melting temperature is reached, the combined structure shown in Figure 3 is held at that temperature for a time between one-half and four minutes. I have discovered that the optimal period of time for an integrated circuit die on the order of 200 mils by 200 mils is about 1.5 minutes, however, as presently understood, the optimum time period depends upon the geometry and size of the die 12. The relatively short time period is of critical importance. If the time is too short the preform will not melt completely. If too long over alloying will result.

The alloy of coating 15 with preform 18 (designated 15/18) which results from this procedure is not well understood, but comprises at least an alloy of gold/tin/silver, and may include some chromium. It is presently believed that not all of coating 15 melts, and for this reason a thin layer of coating 15 is shown above alloy 15/18. Of substantial advantage, however, is the fact that the resulting alloy typically melts at approximately 440°C, rather than about 288°C, the temperature at which it was formed. This change in melting temperature permits the die attach process of this invention to be used with die which are subjected to subsequent thermal processes, but cannot be subjected to high temperature.

The process described above is particularly advantageous in that no gold is required on the wafer. Instead, chromium and silver are used. Further, I have found that die attach wetting occurs easily at 300°C, and that by the use of gold coating on substrate 20 scrubbing of the die 12 against the substrate 20 to accomplish wetting is unnecessary. When other metals are used to coat the die attach region 25 of substrate 20, however, minimal scrubbing may be required. Scrubbing is the motion of the die 12 relative to the substrate 20 to permit complete wetting of the die surface to be attached to substrate 20.

The process described above is particularly advantageous in the assembly of heat-sensitive products such as charge coupled device image sensors and memories. A more general advantage is that by elimination of scrubbing, yields are increased and automated systems, for example, conveyor type heaters, may be utilized to attach the die to the substrate.

Although several embodiments of the invention have been described above, it will be evident to those skilled in the art that numerous variations may be employed without departing from the scope of the appended claims below.

WHAT IS CLAIMED IS:

    1.  A method for attaching an integrated circuit to a substrate comprising:

    coating a surface of the integrated circuit with a composition including silver;

    coating a surface of the substrate with a metal comprising at least one of gold, silver, platinum and palladium; and

    attaching the surface of the integrated circuit to the surface of the substrate with a melted composition of gold and tin.

2. A method as in claim 1 wherein the composition of gold and tin comprises a substantially eutectic composition.

3. A method as in claim 2 wherein the composition comprises approximately 80 percent gold and 20 percent tin by weight.

4. A method as in claim 1 wherein the step of coating a surface of the integrated circuit comprises coating the surface of the integrated circuit with a mixture of silver and chromium.

5. A method as in claim 4 wherein the step of coating comprises:
depositing chromium on the surface of the integrated circuit;
depositing silver while continuing to deposit chromium; and
ceasing to deposit chromium while continuing to deposit silver, then ceasing to deposit silver.

6. A method as in claim 1 wherein the step of attaching comprises:
placing a piece of unmelted gold/tin between the surface of the integrated circuit and the surface of the substrate; and
heating the gold/tin to at least its melting point.

7. A method as in claim 6 wherein the step of heating comprises raising the temperature of the unmelted gold/tin to at least 288°C.

8. A method as in claim 7 wherein the temperature is held at least at 288°C for between one-half and four minutes.

8

9. A method as in claim 1 wherein the step of attaching comprises:

providing a melted region of gold/tin on one of the surface of the substrate or the surface of the integrated circuit; and

placing the surface of the other of the substrate or the integrated circuit in the melted region.

10. A method as in claim 1 wherein the step of attaching is followed by cooling the substrate and the integrated circuit to room temperature.·

11. A method for attaching an integrated circuit to a substrate comprising:

coating a surface of the integrated circuit with a graded composition of chromium and silver, the composition being substantially chromium on the surface of the integrated circuit and substantially silver at an outer surface of the composition;

coating a surface of the substrate with a metal comprising at least one of gold, silver, platinum, or palladium;

placing a piece of gold/tin comprising about 80 percent gold and 20 percent tin by weight between the integrated circuit and the substrate;

heating the integrated circuit, the substrate and the gold/tin to at least 288°C for between one-half and four minutes to thereby attach the integrated circuit to the substrate; and

cooling the integrated circuit and the substrate to below 288°C.

FIG.1     1/1

12

15

FIG.2

12

15

18

20

25

FIG.3

15

12

15/18

20